# EUROPÄISCHE PATENTSCHRIFT

(11) **EP 1 869 368 B1**
(45) Veröffentlichungstag und Bekanntmachung des Hinweises auf die Patenterteilung: **26.11.2008**
(21) Anmeldenummer: 06724254.5
(22) Anmeldetag: 12.04.2006
(51) Int. Cl.: F24C 7/08, H01H 36/00, H03K 17/97, H05B 3/74

(54) **BEDIENVORRICHTUNG FÜR EIN ELEKTROGERÄT**
OPERATOR CONTROL DEVICE FOR AN ELECTRIC APPLIANCE
DISPOSITIF DE COMMANDE POUR APPAREIL ELECTRIQUE

(30) Priorität: 14.04.2005 DE 102005018275
(43) Veröffentlichungstag der Anmeldung: 26.12.2007
(73) Patentinhaber: E.G.O. ELEKTRO-GERÄTEBAU GmbH, 75038 Oberderdingen (DE)
(72) Erfinder: WEIGOLD, Matthias, 75045 Walzbachtal (DE)
(74) Vertreter: Ruff, Michael
(86) Internationale Anmeldenummer: PCT/EP2006/003338
(87) Internationale Veröffentlichungsnummer: WO 2006/108619

(56) Entgegenhaltungen:
- EP-A- 0 797 227
- DE-A1- 19 825 310
- DE-A1- 19 859 105
- US-A- 5 646 587

## Beschreibung

### Anwendungsgebiet und Stand der Technik

Die Erfindung betrifft eine Bedienvorrichtung für ein Elektrogerät, vorzugsweise für ein Elektrowärmegerät.

Eine derartige Bedienvorrichtung ist beispielsweise aus der DE 198 59 105 A1 bekannt. Darin ist eine Anordnung zur Steuerung von elektrisch ansteuerbaren Geräten beschrieben, insbesondere von Elektrokochgeräten, bei der ein Bedienelement bewegbar und abnehmbar auf einer Unterlage zum Liegen kommt, die beispielsweise die Oberfläche eines Glaskeramikkochfeldes sein kann. Im Inneren des Bedienelements und unterhalb des Glaskeramikkochfeldes sind jeweils Permanentmagnete angebracht, die so zueinander orientiert sind, dass sie sich gegenseitig anziehen und das Bedienelement dadurch auf dem Glaskeramikkochfeld gehalten wird. Unter der Glaskeramikkochfeldoberfläche sind weiterhin Sensoren angebracht, die eine Magnetfeldstärke detektieren. Wird das Bedienelement auf der Oberfläche des Glaskeramikkochfelds parallel zur Oberfläche verschoben, wird die daraus resultierende Veränderung der eine Anzahl von Sensoren durchflutenden Magnetfeldlinien von diesen Sensoren registriert, wodurch ein Schaltvorgang ausgelöst werden kann. Weiterhin ist eine ähnliche derartige Bedienvorrichtung aus der EP 797 227 A2 bekannt.

### Aufgabe und Lösung

Aufgabe der Erfindung ist es daher, eine Bedienvorrichtung der Eingangs genannten Art zu schaffen, die reproduzierbare Schaltstellungen des Bedienelements und weiterhin eine Anzahl unterschiedlicher Auslösebewegungen ermöglicht.

Gelöst wird diese Aufgabe durch eine Bedienvorrichtung mit den Merkmalen des Anspruchs 1. Vorteilhafte sowie bevorzugte Ausgestaltungen der Erfindung sind Gegenstand der weiteren Ansprüche und werden im Folgenden näher erläutert. Die im folgenden beschriebenen Merkmale der Bedienvorrichtung gelten weitestgehend für beide Ausführungen und werden deswegen nur einmal beschrieben, was jedoch ihre Allgemeingültigkeit nicht beschränkt. Der Wortlaut der Ansprüche wird durch ausdrückliche Bezugnahme zum Inhalt der Beschreibung gemacht.

Die Bedienvorrichtung weist ein Bedienelement auf, das bewegbar und abnehmbar auf einer Halterfläche mittels einer Haltekraft befestigbar ist. Dabei weist das Bedienelement zur Halterfläche hin eine Bedienelement-Unterseite auf und die Halterfläche zum Bedienelement hin eine Halterflächen-Oberseite.

Es ist gemäß der Erfindung die Bedienelement-Unterseite in einem ersten Flächenbereich korrespondierend zur ebenen Halterflächen-Oberseite für eine stabile Lage des Bedienelements als stabile Grundposition ausgebildet, wobei die Haltekraft die stabile Grundposition unterstützt bzw. stabilisiert. Erfindungsgemäß ist hier der erste Flächenbereich von einem zweiten Flächenbereich umgeben, der eine von dem Verlauf des ersten Flächenbereichs abweichende Wölbung oder Krümmung aufweist. Dabei weicht er von der Halterflächen-Oberseite derart zurück, dass das Bedienelement aus der Grundposition bei bleibendem Kontakt zur bzw. Aufliegen auf der Halterfläche gekippt werden kann. Erkennungsmittel zum Erkennen der Position des Bedienelements in der Grundposition oder einer anderen Position und zur Auslösung einer Bedienfunktion sind vorgesehen. Durch die unterschiedliche geometrische Ausgestaltung der Flächenbereiche kann die Bedienvorrichtung von einer ersten Grundposition relativ zur Halterflächen-Oberseite in wenigstens eine zweite Position relativ zur Halterflächen-Oberseite überführt bzw. gekippt werden.

In kurzen Worten gesagt ist die Halterflächen-Oberseite eben und die Bedienelement-Unterseite leicht gewölbt bzw. von dem zweiten zurückweichenden Flächenbereich umgeben. Beim Einsatz in Kochfeldern wird dies bevorzugt, da dann eine ebene Kochfeldplatte aus Glaskeramik verwendet werden kann.

Der erste Flächenbereich bildet mit der gegenüberliegenden Seite eine Kontakt- oder Berührfläche, die derart gestaltet ist, dass das Bedienelement in seiner ersten, lagestabilen Grundposition weitestgehend unbeweglich auf der Halterflächen-Oberseite liegt. Der Vektor der im Schwerpunkt des Bedienelements wirkenden Gewichtskraft kreuzt nämlich die Berührfläche. Durch Verkippen wird das Bedienelement von seiner ersten Grundposition in seine zweite, lageinstabile Position überführt, in der der zweite Flächenbereich die Halterflächen-Oberseite berührt. In dieser zweiten Position schneidet der Vektor der Gewichtskraft nicht die Berührfläche, so dass sich das Bedienelement wieder in seine erste Grundposition zurück bewegt, sobald die Kraft, die die Kippbewegung des Bedienelements verursacht hat, nicht mehr einwirkt. Das selbsttätige Zurückbewegen des Bedienelements von seiner zweiten Stellung in seine erste entspricht sozusagen der Rückbewegung eines Tasters.

Die Erkennungsmittel zum Erkennen der Position des Bedienelements können wahrnehmen, ob das Bedienelement überhaupt an der Halterflächen-Oberseite anliegt bzw. in welcher Stellung sich das Bedienelement befindet. So kann das Auflegen und das Abnehmen des Bedienelements auf und von der Halterflächen-Oberseite beispielsweise dazu verwendet werden, das Elektrogerät an- und auszuschalten. Das Verkippen des Bedienelements kann einerseits zur Erzeugung stufenweiser Schaltvorgänge verwendet werden, indem der Kippvorgang des Bedienelements generell zum Auslösen einer Bedienfunktion herangezogen wird. Andererseits kann die Dauer des Verkippens des Bedienelements mittels der Erkennungsmittel registriert werden und abhängig von der Dauer ein stufenloser Schaltvorgang ausgelöst werden, der dem eines Dimmers ähnelt. Es ist weiterhin möglich, dass dem Bedienelement neben der Kippschalterfunktion noch die Funktion eines Drehreglers oder eines Schiebereglers zugeordnet ist.

In einer Ausgestaltung der Erfindung ist die Bedienelement-Unterseite oder die Halterflächen-Oberseite eben und der erste Flächenbereich der anderen Seite ebenfalls eben. Dadurch ergeben sich zwei korrespondierende parallele ebene Flächen, die eine stabile Lagerung des Bedienelements ermöglicht.

In einer Ausgestaltung der Erfindung ist der zweite Flächenbereich von der anderen Seite weg abgerundet zurückgewölbt, vorzugsweise gleichmäßig abgerundet. Dadurch geschieht das Verkippen des Bedienelements durch eine einwirkende Kraft, die nicht die Gewichtskraft des Bedienelements ist, nicht spontan und schlagartig. Das Bedienelement rollt vielmehr über den zweiten Flächenbereich ab. Die Kippbewegung wird dadurch bei geraden Flächen besser kontrollierbar. Alternativ ist eine Abwinklung mit einer Kante möglich, die einem exakten und signifikanten Schaltpunkt entspricht.

In einer Ausgestaltung der Erfindung weist der Übergang zwischen dem ersten Flächenbereich und dem zweiten Flächenbereich einen diskontinuierlichen Verlauf bzw. eine Stufe auf. Eine Bedienperson, die mit dem Bedienelement eine Bedienfunktion auslösen möchte, kann wegen der Stufe bzw. des diskontinuierlichen Verlaufs spüren, dass das Bedienelement ausreichend verkippt ist, da von der Bedienperson eine Art Schnappen wahrgenommen wird.

In einer Ausgestaltung der Erfindung ist die Halterflächen-Oberseite eben und die Bedienelement-Unterseite weist den ersten Flächenbereich und den zweiten Flächenbereich auf. Diese Ausgestaltung ermöglicht es beispielsweise, dass die Halterflächen-Oberseite eben und flach ist, vorzugsweise die Oberseite eines Glaskeramikkochfeldes, zur Vermeidung störender Unebenheiten auf der Oberseite des Geräts. Die Kippbarkeit kann somit nur durch das Bedienelement erreicht werden.

In einer Ausgestaltung der Erfindung ist der erste Flächenbereich kreisrund und der zweite Flächenbereich nach Art eines kalottenförmigen Rings ausgebildet, wobei der erste Flächenbereich entlang des Kreisrings direkt, vorteilhaft gleichmäßig, in den zweiten Flächenbereich übergeht. Der kreisrunde erste Flächenbereich und der direkte Übergang in den zweiten Flächenbereich machen die Ausrichtung des Bedienelements auf der Oberfläche und relativ zu den Erkennungsmitteln gleichgültig. Es spielt weiterhin keine Rolle, auf welcher Ebene des Bedienelements und in welche Richtung das Bedienelement verkippt werden muss, um eine Bedienfunktion auszulösen.

In einer anderen Ausgestaltung der Erfindung ist der erste Flächenbereich mehreckig, vorzugsweise gleichseitig bzw. gleichmäßig, und der zweite Flächenbereich mit fortgesetzten prismaähnlichen Teilflächen ausgebildet, wobei der erste Flächenbereich entlang der Außenkante des Mehrecks direkt in den zweiten Flächenbereich übergeht. Die mehreckige Ausgestaltung des ersten Flächenbereiches ermöglicht ein definiertes Verkippen des Bedienelements in mehrere Richtungen auf einer Ebene, so dass wenigstens zwei unterschiedliche Schaltvorgänge ausgelöst werden können. Die mögliche Anzahl der unterschiedlichen Schaltvorgänge entspricht dabei wenigstens der Anzahl der Kanten des ersten Flächenbereichs.

In einer Ausgestaltung der Erfindung ist die Haltekraft die Schwerkraft. Dies ermöglicht einen sehr geringen mechanischen und fertigungstechnischen Aufwand, da das Bedienelement einteilig, beispielsweise in einem Spritzgussverfahren, hergestellt werden kann. Weitere Anbauteile an dem Bedienelement sind für die Haltekraft nicht unbedingt nötig.

In einer Ausgestaltung der Erfindung ist eine Stabilisierungseinrichtung zur Erzeugung der Haltekraft vorgesehen, vorzugsweise auf kontaktlose Art und Weise, insbesondere durch Magnetkraft. Dabei kann an einer der beiden Seiten der Bedienelement-Unterseite oder der Halterflächen-Oberseite ein aktiver Magnet und an der anderen Seite magnetisches Material oder ein zweiter aktiver Magnet angeordnet sein. Die aktiven Magnete können Permanentmagnete oder beispielsweise Spulen sein. Durch das Anordnen eines Magnetes entweder an der Bedienelement-Unterseite oder der Halterflächen-Oberseite und einem entsprechenden Gegenstück an der jeweils anderen Seite wird das Bedienelement in seiner Position auf der Halterflächen-Oberseite fixiert. Ist der aktive Magnet an der Bedienelement-Unterseite angeordnet, bietet sich außerdem die Möglichkeit der einfachen Lagerung bei Nichtverwendung der Bedienelemente und des Elektrogeräts an jeder magnetisierbaren Oberfläche an, beispielsweise einer Kühlschranktür.

In weiterer Ausgestaltung der Erfindung arbeiten die Erkennungsmittel kontaktlos, vorzugsweise durch Magnetkraft bzw. ein Magnetfeld. Dabei sind insbesondere in dem Bedienelement ein aktiver Magnet angeordnet und unter der Halterfläche Magnetfeldsensoren zur Erkennung der Veränderung des Magnetfelds im Bedienelement infolge des Kippens des Bedienelements, insbesondere aus der Grundposition heraus. Die kontaktlos arbeitenden Erkennungsmittel sind vorzugsweise Hall-Sensoren. Diese können sowohl analog als auch digital und weiterhin mit programmierbaren oder festen Eigenschaften ausgestattet sein. Zur Auswertung der Signale der Hall-Sensoren ist eine elektronische Steuerung als Teil der Erkennungsmittel denkbar.

Das Verkippen des Bedienelements erzeugt einen in einem Winkel ausgebildeten Spalt zwischen der Halterflächen-Oberseite und der Bedienelement-Unterseite. Der Magnet, der an der Unterseite des Bedienelements angeordnet ist, weist somit an seinen Polen unterschiedliche Abstände zu den Magnetfeldsensoren auf. Diese Unterschiede der Abstände haben auch Unterschiede in den Magnetfeldern zur Folge und werden ebenfalls von den Sensoren detektiert, um sie beispielsweise zur Erzeugung eines Schaltvorgangs heranzuziehen.

Vorzugsweise sind die Magnetfeldsensoren paarweise gegenüberliegend unter der Halterfläche angeordnet, wobei jeweils ein Magnetfeldsensor in einem Bereich der Halterfläche angeordnet ist, der zu einem der Pole des Magnetes im Bedienelement benachbart ist.

Es können weitere Magnetfeldsensoren um die Stelle herum unter der Haltefläche des Bedienelements verteilt angeordnet sind. Vorteilhaft sind die Sensoren kreisförmig angeordnet. Es ist jedoch ebenfalls denkbar, die Sensoren in weiteren geometrischen Formen anzuordnen. Mehrere Magnetfeldsensoren, angeordnet um die Berührstelle des Bedienelements herum, ermöglichen das einfache Detektieren unterschiedlicher Verkippungsrichtungen des Bedienelements. Weiterhin kann so ein Verdrehen des Bedienelements auf der Halterfläche ebenfalls sehr einfach und mit einer groben Auflösung der Sensoren wahrgenommen werden. Das Verdrehen kann dann beispielsweise herangezogen werden, um verschiedene Schaltstufen eines Elektrowärmegerätes einzustellen. Das Elektrogerät kann eine weitere Erkennungseinrichtung zur Erkennung einer Drehbewegung des Bedienelements und zum Auslösen einer Bedienfunktion aufweisen, wobei vorzugsweise diese Erkennungseinrichtung weitere Magnetfeldsensoren an oder unter der Halterfläche aufweist, die mit einem oder mehreren Magneten an oder im Bedienelement zusammenwirken. Das Bedienelement kann somit als Drehschalter verwendet werden. Die Feldlinien des Magneten, der im Bedienelement angeordnet ist, können beispielsweise durch einen Blechstreifen in ihrem Einflussbereich vergrößert werden. Der Blechstreifen sollte dazu parallel und kongruent zu einer Linie ausgerichtet sein, die die beiden Pole des Magneten im oder am Bedienelement verbindet.

In einer Ausgestaltung der Erfindung ist der Magnet der Erkennungsmittel der Magnet der Stabilisierungseinrichtung. Neben der Möglichkeit, auf diese Weise wenigstens einen Magneten zu sparen, ergibt sich aus dieser Ausgestaltung weiterhin, dass sich keine ungewollte Überschneidung der Magnetfeldlinien einstellt. Diese kann zu Verfälschungen der zu detektierenden Feldlinien führen.

In einer Ausgestaltung der Erfindung kann das Bedienelement in mehrere Richtungen gekippt werden, vorzugsweise durch eine kraftgeführte Kippbewegung. Die Kraft für die Kippbewegung wird benötigt, um die Anziehungskraft des Magneten auf sein Gegenstück zu überwinden. Vorzugsweise ist die Magnetkraft gering, hält das Bedienelement aber sicher in der Grundposition. Sie sollte zumindest durch einen geringen Kraftaufwand einer Betätigungsperson überwunden werden können.

In weiterer Ausgestaltung der Erfindung weist das Bedienelement einen Magneten an einem höheren Punkt auf, wobei an oder unter der Haltefläche zwei weitere voneinander beabstandete Magnete vorgesehen sind. Diese weisen einen Abstand zu dem Punkt auf, an dem das Bedienelement auf die Haltefläche gesetzt ist, wobei sich bei der Kippbewegung der Magnet in dem Bedienelement einem Punkt zwischen den beiden Magneten an oder unter der Haltefläche nähert. Dabei stoßen sich der Magnet im Bedienelement und die Magnete an oder unter der Haltefläche gegenseitig ab. Dadurch wird das verkippte Bedienelement durch die aufeinanderzuweisenden, gleichnamigen Pole der Magnete bei seiner Bewegung von der Verkippung in die stabile Grundposition beziehungsweise entlang einer stabilisierenden Richtung unterstützt.

Alternativ zu einer Erfassung der Drehung durch Magnetkraft kann eine Erkennung auf optischem Weg erfolgen. Dazu kann ein Sensor vorgesehen sein, vorteilhaft unter der Halterfläche. Damit wirkt ein kreisringartiger Sensorauslöser zusammen, wobei der Sensorauslöser an der Unterseite des Bedienelements sitzt und eine Abfolge von Auslösebereichen und Zwischenbereichen aufweist. Zwischen dem Sensor und dem Sensorauslöser findet die Drehung statt mit Hin- und Zurückrichtung, was der Sensor erkennt. Eine derartige Anordnung ist bekannt aus der DE 10330912 A1, auf die hiermit ausdrücklich Bezug genommen wird.

Zur besseren Einteilung einer Drehbewegung in einzelne Stufen, insbesondere bei der Einstellung von Leistungsstufen, kann eine magnetische Rasteinrichtung vorgesehen sein. Diese bewirkt mittels Magnetkraft bzw. zusammenwirkenden Magneten eine Unterteilung der Drehbewegung in einzelne Raststufen. Üblicherweise sind derartige Rasteinrichtungen mechanisch. Beispielsweise weisen sie einen fünf- oder mehrarmigen Metallstern mit Magnet auf, der mit entsprechend vielen Magneten auf der anderen Seite zusammenwirkt. Der Vorteil einer magnetischen Rasteinrichtung liegt jedoch vor allem darin, dass eine geschlossene Halterfläche vorgesehen sein kann. Vor allem kann eine solche magnetische Rasteinrichtung auch ein definiertes, vorbeschriebenes Kippen des Bedienelements bewirken bzw. unterstützen. Eine derartige magnetische Rasteinrichtung ist beispielsweise in der EP 797 227 A1 bekannt, auf die diesbezüglich ausdrücklich Bezug genommen wird.

Neben Anwendungen für die Leistungssteuerung bzw. Bedienung von Elektrokochgeräten wie beispielsweise Kochfeldern, insbesondere mit Kochfeldplatten, die die Halterfläche bilden, sind weitere Möglichkeiten gegeben. So können Safeschlüssel nach diesem Prinzip ausgebildet sein. Durch die Drehung und die Kippbewegungen kann eine relativ aufwendige Gesamtkombination vorgegeben werden, die durch Probieren schwer zu ermitteln ist. Des weiteren ist eine Dimmerschaltung für Lampen möglich. Durch die Kippbewegung kann eine bestimmte Lampe ausgewählt werden. Durch die Drehbewegung kann die Helligkeit eingestellt werden. Schließlich sind zahlreiche weitere Verwendungen denkbar, bei denen die Bedieneinheit im wesentlichen hinter einer geschlossenen Fläche liegt.

Diese und weitere Merkmale gehen sowohl aus den Ansprüchen als auch aus der Beschreibung und den Zeichnungen hervor, wobei die einzelnen Merkmale jeweils für sich allein oder zu mehreren in Form von Unterkombinationen bei einer Ausführungsform der Erfindung und auf anderen Gebieten verwirklicht sein und vorteilhafte sowie für sich schutzfähige Ausführungen darstellen können, für die hier Schutz beanspruch wird. Die Unterteilung der Anmeldung in einzelne Abschnitte sowie Zwischenüberschriften beschränkt die unter diesen gemachten Aussagen nicht in ihrer allgemeinen Gültigkeit.

### Kurzbeschreibung der Zeichnungen

Ausführungsbeispiele der Erfindung sind in den Zeichnungen schematisch dargestellt und werden im folgenden näher erläutert. In den Zeichnungen zeigt:
- Fig.1: eine Draufsicht eines Kochfeldes mit einer Anordnung der Bedienvorrichtung im Randbereich des Kochfel- des,
- Fig. 2: eine geschnittene Seitenansicht der Bedienvorrich- tung mit dem Bedienelement, dass von dem Kochfeld abgehoben ist,
- Fig.3: eine geschnittene Seitenansicht der Bedienvorrich- tung mit dem Bedienelement, dass auf dem Kochfeld aufgesetzt ist,
- Fig.4: eine geschnittene Seitenansicht der Bedienvorrich- tung mit dem Bedienelement, dass auf dem Kochfeld verkippt ist,
- Fig. 5a und5b: geschnittene Draufsichten auf die Bedienvorrichtung in unterschiedlichen Drehpositionen,
- Fig. 6a bis 6c: Unteransichten des Bedienelements mit unterschied- lich gestalteten Flächenbereichen,
- Fig. 7a bis 7c: Geschnittene, seitliche Detailansichten der Untersei- ten der Bedienelemente gemäß Schnittlinien Vlla- Vlla, VIIb-VIIb und VIIc-VIIc in den Fig. 6a, Fig. 6b und Fig. 6c und
- Fig. 8 und 9: eine Abwandlung der Darstellungen aus Fig. 3 und 4.

### Detaillierte Beschreibung der Zeichnungen

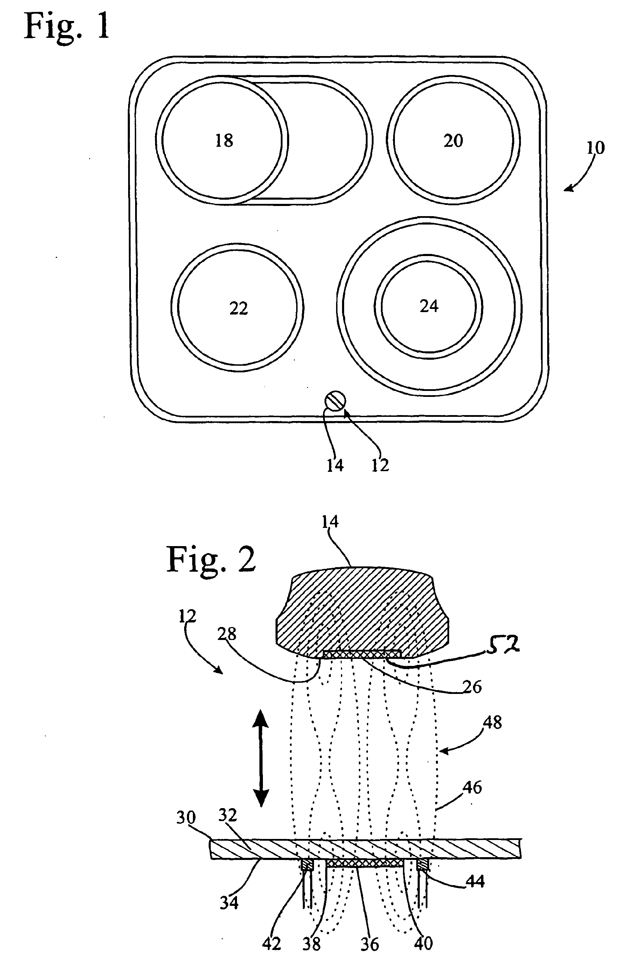

Fig. 1 zeigt ein Kochfeld 10 mit einer möglichen Anordnung der Bedienvorrichtung 12 in einem Randbereich des Kochfelds 10. An der Unterseite 28 des Bedienelements 14 ist, wie der Fig. 2 zu entnehmen ist, ein Magnet 26 vorgesehen. Die Unterseite 28 steht der Oberseite 30 einer Glaskeramikplatte 32 gegenüber bzw. liegt auf ihr auf. An der Unterseite 34 der Glaskeramikplatte 32 ist ebenfalls ein Magnet 36 angeordnet. Sowohl im linken Randbereich 38 als auch im rechten Randbereich 40 des Magneten 36 ist jeweils entsprechend ein linker Magnetfeldsensor 42 und ein rechter Magnetfeldsensor 44 angeordnet. Zur besseren Drehbarkeit bei gleichzeitig aufrecht erhaltener Zentrierung kann die Unterseite 28 bzw. der Magnet 26 eine kleine Wölbung oder Zentriererhebung aufweisen.

Das Bedienelement 14 ist in Fig. 2 gerade so nah an die Glaskeramikplatte 32 herangeführt, dass sich die Magnetfeldlinien 46 der Magnete 26, 36 gerade überschneiden. Die Magnete 26, 36 bilden ein gemeinsames Magnetfeld 48, dass stärker ist als die einzelnen Magnetfelder der Magnete 26, 36. Je näher das Bedienelement 14 an die Glaskeramikkochplatte 32 herangeführt wird, desto stärker wird das Magnetfeld 48. Die Magnetfeldsensoren 42, 44 registrieren diese Veränderung. Haben das Bedienelement 14 und die Glaskeramikplatte 32 einen bestimmten Abstand unterschritten, wird durch eine nicht dargestellte elektronische Schaltung, die mit den Magnetfeldsensoren 42, 44 elektrisch verbunden ist, ein Schaltvorgang ausgelöst. Somit kann das Bedienelement 14 durch die Annäherung an das und das Entfernen von dem Glaskeramikkochfeld beispielsweise für eine Hauptschalterfunktion des Elektrogeräts verwendet werden.

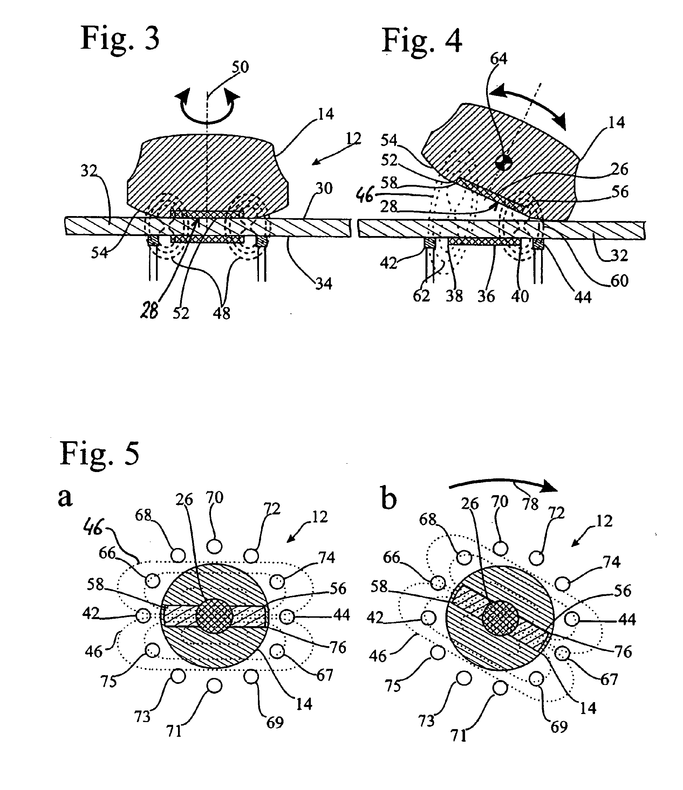

In Fig. 3 liegt die Unterseite 28 des Bedienelements 14 an der Oberseite 30 der Glaskeramikplatte 32 an. In der dargestellten Position ist beispielsweise eine Drehbewegung des Bedienelements 14 um eine Achse 50 vorstellbar. Die Drehbewegung des Bedienelements 14 verändert unter anderem die Position der Pole der Magnete 26, 36 zueinander, wodurch sich die Stärke des Magnetfelds 48 an bestimmten Punkten verringert. Die Veränderung des Magnetfelds 48 kann dann erkannt und dazu verwendet werden, mit der Bedienvorrichtung die Funktion eines herkömmlichen mechanischen Drehschalters zu ersetzen.

Wie der Fig. 3 zu entnehmen ist, ist die Unterseite 28 des Bedienelements 14 in zwei unterschiedlich gestaltete Bereiche aufgeteilt. Zum einen ist dies der ebene Bereich 52, auf dem das Bedienelement 14 in der in Fig. 3 dargestellten Position auf der Glaskeramikplatte aufliegt. Zum anderen ist dies ein gekrümmter Bereich 54. Die Krümmung des Bereichs 54 verläuft dabei von dem ebenen Bereich 52 ausgehend in eine Richtung, die von der Glaskeramikplatte 32 weg weist.

Die gewölbte Form des Bereichs 54 wird benötigt, um ein Verkippen des Bedienelements 14 gemäß Fig. 4 zu ermöglichen. Die dargestellte Verkippung des Bedienelements 14 bewirkt, dass die Pole 56, 40 der Magnete 26, 36 in einer annähernd unveränderten Position zueinander stehen. Ihr gemeinsames Magnetfeld 60 bleibt im Vergleich zum unverkippten Zustand des Bedienelements annähernd gleich.

Die Pole 38, 58 der Magnete 26, 36 entfernen sich jedoch durch die Verkippung des Bedienelements 14 deutlich voneinander. Dadurch wird das gemeinsame Magnetfeld 62 der Magnete 26, 36 im Bereich der Pole 38, 58 abgeschwächt. Der Magnetfeldsensor 44 detektiert die Feldstärke des Magnetfelds 60 und der Magnetfeldsensor 42 detektiert die Feldstärke des Magnetfelds 62. Die Unterschiede der Magnetfeldstärken der Magnetfelder 60, 62 kann mittels einer nicht dargestellten Auswerteelektronik festgestellt werden, die entsprechend der Unterschiede der Feldstärken einen Schaltvorgang auslöst. Denkbar ist auch ein mehrstufiger Schaltvorgang abhängig von unterschiedlichen Öffnungswinkeln beziehungsweise Kipp-Stellungen zwischen der Unterseite des Bedienelements 28 und der Halteflächen-Oberseite 30.

Das Bedienelement 14 kann beispielsweise durch eine Bedienperson in die gekippte Lage überführt werden. Lässt die Bedienperson das Bedienelement 14 in seiner gekippten Lage wieder los, begibt sich das Bedienelement, einem Taster gleich, wieder in seine ungekippte, lagestabile Grundposition relativ zur Glaskeramikplatte 32 gemäß Fig. 3. Dies geschieht aufgrund der Wölbung des Bereichs 54 und des Verlaufs des Vektors der Gewichtskraft des Bedienelements 14, die im Schwerpunkt 64 angreift. Durch das Verkippen des Bedienelements 14 verläuft der Vektor der Gewichtskraft des Bedienelements 14 nicht durch die Berührfläche zwischen Bedienelement 14 und Glaskeramikfeld 32.

Die Fig. 5a und 5b zeigen geschnittene Draufsichten der Bedienvorrichtung 12, wobei das Bedienelement 14 jeweils in einer anderen Richtung ausgerichtet ist. Um das Bedienelement 14 herum sind kreisförmig jeweils paarweise gegenüberliegende Magnetfeldsensoren 42, 44, 66, 67, 68, 69, 70, 71, 72, 73, 74, 75 angeordnet.

Im Inneren des Bedienelements 14 ist neben dem Magneten 26 noch ein Blechstreifen 76 angeordnet. Er verläuft parallel zu einer nicht dargestellten Verbindungslinie der beiden Pole 56, 58 des Magneten 26. Der Blechstreifen 76 dient zur gezielten Ausrichtung und Vergrößerung der Ausdehnung der Magnetfeldlinien 46. Er könnte zur Erzielung der Wirkung des vorgenannten Sterns der magnetischen Rasteinrichtung auch mehrarmig sein, beispielsweise fünfarmig. Auch hier kann eine gezielte Ausrichtung und Vergrößerung der Ausdehnung von Magnetfeldlinien erfolgen für das Zusammenwirken mit entsprechend angeordneten Magneten.

In Fig. 5a ist das Bedienelement 14, und somit auch die Verbindungslinie der Pole 56, 58 des Magneten 26, derart ausgerichtet, dass sie kongruent zur Verbindungslinie der Magnetfeldsensoren 42, 44 ist. In Fig. 5b ist das Bedienelement 14 beispielhaft um etwa 30° entsprechend der durch den Pfeil 78 dargestellten Richtung gedreht dargestellt. Somit verläuft die Verbindungslinie der Pole 56, 58 des Magneten 26 kongruent zur Verbindungslinie der Magnetfeldsensoren 66, 67 ausgerichtet. Durch die Drehung des Bedienelements 14, und der daraus resultierenden Drehung des Magnetfeldes, werden je nach Stellung des Bedienelements 14 von unterschiedlichen Magnetfeldsensoren unterschiedlich starke Magnetfelder detektiert. Anhand dieser Unterschiede lässt sich, beispielsweise mittels einer Auswerteelektronik, ein Schaltsignal auslösen.

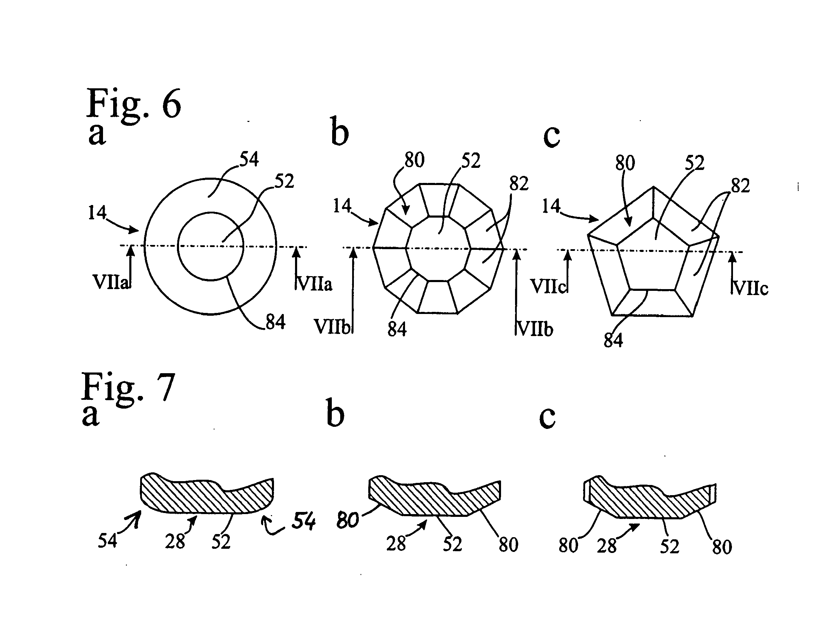

In den Fig. 6a, 6b und 6c sind unterschiedliche Ausführungsmöglichkeiten der Unterseite 28 eines Bedienelements 14 dargestellt. Die Fig. 6a zeigt die Unterseite 28 in einen inneren Bereich 52 und einen ringartigen äußeren Bereich 54 aufgeteilt. Die beiden Bereiche sind kreisrund ausgebildet und konzentrisch zueinander ausgerichtet. Es ist jedoch ebenfalls möglich, die Bereiche 52, 54 nicht kreisrund sondern vielmehr mehreckig zu gestalten, beispielsweise zehneckig, wie in Fig. 6b dargestellt, oder fünfeckig, wie in Fig. 6c dargestellt. Die mehreckige Ausgestaltung der Bedienelemente 14 weist ebenfalls einen inneren Bereich 54 auf, der von einem äußeren Bereich 80 umgeben ist. Die äußeren Bereiche 80 sind, entsprechend der Anzahl der Kanten 84 der Bedienelemente 14, in verschiedene Facetten 82 unterteilt. Dabei sind der innere Bereich 52 und der äußere Bereich 80 vorzugsweise so angeordnet, dass alle Facetten 82 eines mehreckigen Bedienelements 14 gleich groß sind. Die Anzahl der Kanten entspricht auch der mindesten Anzahl der möglichen Kipp-Bewegungen der Bedienelemente 14, um einen definierten Schaltvorgang auslösen zu können.

Mögliche unterschiedliche Gestaltungsmöglichkeiten des äußeren Bereichs 54, 80 des Bedienelements 14 sind beispielhaft in den Fig. 7a, 7b und 7c in Seitenansicht dargestellt. Allen Gestaltungsmöglichkeiten ist dabei der innere Bereich 54 insofern gleich, als dass er eben und, wenn er mit einer Auflagefläche 32 eine Kontakt- oder Berührfläche bildet, parallel zu der Auflagefläche 32 ausgebildet ist, siehe Fig. 2, 3 und 4.

Die Fig. 7a zeigt einen gekrümmten Verlauf des äußeren Bereichs 54, 80 eines kreisförmig ausgebildeten Bedienelements 14 gemäß Fig. 6a oder 6b. Der weist vom inneren Bereich 52 des Bedienelements 14 und einer nicht dargestellten Auflagefläche weg, mit dem der innere Bereich 52 eine Kontakt- oder Berührfläche bildet. Entsprechend der Schnittlinie Vllb-Vllb in Fig. 6b zeigt die Fig. 7a den Bereich 80 an einer Berührstelle zweier Facetten 82.

Eine andere mögliche Geometrie des äußeren Bereichs 54, 80 eines kreisförmigen oder mehreckigen Bedienelements 14 zeigt die Fig. 7b. Der dargestellte Verlauf ist eben und weist vom inneren Bereich 52 des Bedienelements 14 und einer nicht dargestellten Auflagefläche weg, mit der der innere Bereich 52 eine Kontakt- oder Berührfläche bildet.

Die Fig. 7c ist eine Detailansicht eines gemäß der Linie Vllc-Vllc in Fig. 6c geschnittenen, fünfeckigen Bedienelements 14. Die Darstellung zeigt den schrägen, äußeren Bereich 80 des fünfeckigen Bauelements 14 in einem Innenbereich seiner Facetten 82, so wie er ebenfalls bei jedem anderen mehreckigen Bedienelement 14 gestaltet sein kann.

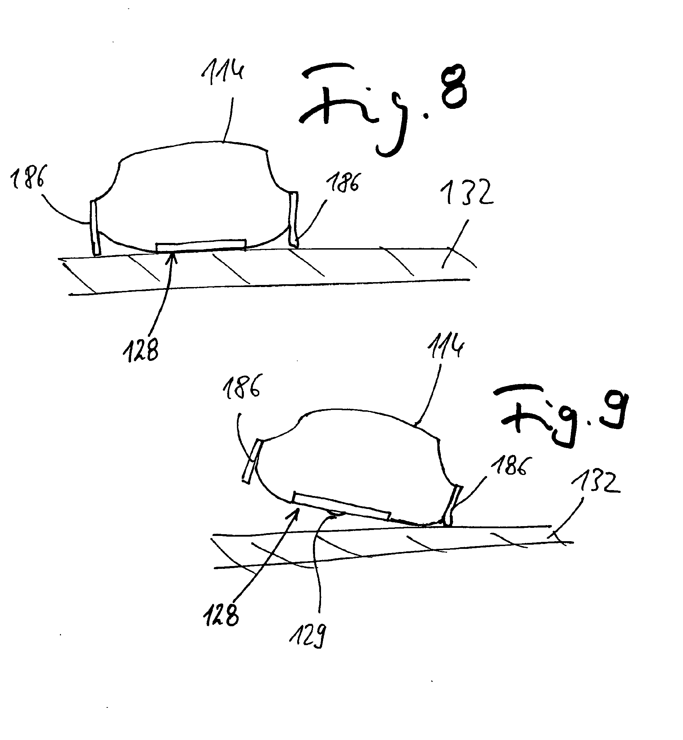

Die Fig. 8 und 9 zeigen eine Abwandlung der Darstellungen aus den Fig. 3 und 4. Hier ist an der Unterseite 128 des Bedienelements 114 am Außenrand eine Art herunterhängender oder nach unter reichender elastischer Schürze 186 vorgesehen. Sie kann als außen umlaufendes Gummiband odgl. ausgebildet sein. Alternativ kann sie weniger zum Stauchen als vielmehr zur seitlichen Ausweichbewegung ausgebildet sein. So ist sogar eine Art Scharnierfunktion denkbar. Die Schürze 186 reicht bei normaler, aufrechter Lage gem. Fig. 8 bis kurz vor die Oberseite der Glaskeramikplatte 132. Es besteht also keine Reibung beim Drehen. Alternativ könnte die Schürze 186 gerade auf die Glaskeramikplatte 132 reichen, sodass die Reibung sehr gering ist.

Die Wirkung dieser Schürze 186 ist, dass dadurch eine gewisse Stabilität gegen Kippen gegeben ist bzw. eine erhöhte Kraft notwendig ist zum Kippen des Bedienelements 132, die dennoch von einer Bedienperson leicht aufgebracht werden kann. Dazu kann die Schürze 186 beispielsweise relativ dünn oder aus entsprechend elastischem Material gefertigt sein. In Fig. 9 ist bei nach rechts verkipptem Bedienelement 132 zu erkennen, wie hier die Schürze 186 gestaucht bzw. zur Seite gebogen ist.

Durch spezielle Formgebung einer solchen Schürze kann allgemein auch eine bestimmte Kipprichtung vorgegeben werden. So ist etwa ein Verbiegen oder Stauchen der Schürze nur in bestimmte Richtungen möglich. Ein weiterer Vorteil einer solchen Schürze liegt auch darin, dass die seitliche Erhebung des Randes über die Auflagefläche nicht zu erkennen ist. So ist ein aufgeräumterer Eindruck gegeben.

Darüber hinaus ist in Fig. 9 noch eine Zentrierwölbung 129 an der Unterseite 128 dargestellt. Sie ist mittig angebracht und dient der leichteren und punktgenaueren Drehbarkeit. Die Zentrierwölbung 129 kann beispielsweise durch einen kleinen Materialauftrag bzw. ein aufgeklebtes Element ausgebildet sein.

## Patentansprüche

1. Bedienvorrichtung (12) für ein Elektrogerät, vorzugsweise ein Elektrowärmegerät, wobei die Bedienvorrichtung (12) ein Bedienelement (14) aufweist, das bewegbar und abnehmbar mit einer Bedienelement-Unterseite (28) auf einer Halterfläche (32) mit einer Halterflächen-Oberseite (30) mittels einer Haltekraft aufliegt, **dadurch gekennzeichnet, dass** die Bedienelement-Unterseite (28) in einem ersten Flächenbereich (52) korrespondierend zur ebenen Halterflächen-Oberseite (30) für eine stabile Lage des Bedienelements (14) in einer kippstabilen Grundposition ausgebildet ist, wobei die Haltekraft die Grundposition unterstützt, wobei dieser erste Flächenbereich (52) von einem zweiten Flächenbereich (54) umgeben ist, der eine von dem Verlauf des ersten Flächenbereichs (52) abweichende Wölbung aufweist und dabei von der Halterflächen-Oberseite (30) derart zurückweicht, dass das Bedienelement (14) aus der Grundposition bei bleibendem Aufliegen zur Halterfläche hin kippbar ist, wobei Erkennungsmittel (42, 44, 66, 67, 68, 69, 70, 71, 72, 73, 74, 75) zum Erkennen der Position des Bedienelements (14) in der Grundposition oder einer anderen Position und zur Auslösung einer Bedienfunktion vorgesehen sind.

2. Bedienvorrichtung nach Anspruch 1, **dadurch gekennzeichnet, dass** die Bedienelement-Unterseite (28) im ersten Flächenbereich (52) ebenfalls im wesentlichen eben ist.

3. Bedienvorrichtung nach einem der vorhergehenden Ansprüche, **dadurch gekennzeichnet, dass** der zweite Flächenbereich (54) abgerundet zurückgewölbt ist von der anderen Seite weg, vorzugsweise gleichmäßig abgerundet.

4. Bedienvorrichtung nach einem der vorhergehenden Ansprüche, **dadurch gekennzeichnet, dass** der Übergang zwischen erstem Flächenbereich (52) und zweitem Flächenbereich (54) einen diskontinuierlichen Verlauf bzw. eine Stufe aufweist, wobei er insbesondere aneinander anschließt.

5. Bedienvorrichtung nach einem der vorhergehenden Ansprüche, **dadurch gekennzeichnet, dass** der erste Flächenbereich (52) kreisrund ist und der zweite Flächenbereich (54) nach Art eines teilkalottenartigen Ringes ausgebildet ist, wobei der erste Flächenbereich (52) entlang eines Kreisringes direkt in den zweiten Flächenbereich (54) übergeht.

6. Bedienvorrichtung nach einem der Ansprüche 1 bis 4, **dadurch gekennzeichnet, dass** der erste Flächenbereich (52) mehreckig ist, vorzugsweise gleichseitig bzw. gleichmäßig, und der zweite Flächenbereich (54) mit fortgesetzten prismaähnlichen Teilflächen ausgebildet ist, wobei der erste Flächenbereich (52) entlang der Außenkanten des Mehrecks direkt in den zweiten Flächenbereich (54) übergeht.

7. Bedienvorrichtung nach einem der vorhergehenden Ansprüche, **dadurch gekennzeichnet, dass** die Haltekraft die Schwerkraft ist.

8. Bedienvorrichtung nach einem der Ansprüche 1 bis 6, **gekennzeichnet durch** eine Stabilisierungseinrichtung zur Erzeugung der Haltekraft, vorzugsweise auf kontaktlose Art und Weise, insbesondere durch Magnetkraft, wobei vorzugsweise an einer der beiden Seiten der Bedienelement-Unterseite (28) oder im Bereich der Halterfläche (32) ein aktiver Magnet (26, 36) und an der anderen Seite magnetisches Material oder ein zweiter aktiver Magnet angeordnet sind.

9. Bedienvorrichtung nach einem der vorhergehenden Ansprüche, **dadurch gekennzeichnet, dass** die Erkennungsmittel (42, 44, 66, 67, 68, 69, 70, 71, 72, 73, 74, 75) für kontaktlose Erkennung ausgebildet sind, vorzugsweise durch Magnetkraft bzw. ein Magnetfeld (48, 60, 62), wobei insbesondere in dem Bedienelement (14) ein aktiver Magnet (26) angeordnet ist und unter der Halterfläche (32) Magnetfeldsensoren (42, 44, 66, 67, 68, 69, 70, 71, 72, 73, 74, 75) zur Erkennung der Veränderung des Magnetfelds (48, 60, 62) im Bedienelement (14) infolge eines Kippens des Bedienelements (14), insbesondere aus der Grundposition zur Halterfläche (30) hin.

10. Bedienvorrichtung nach Anspruch 9, **dadurch gekennzeichnet, dass** weitere Magnetfeldsensoren (42, 44, 66, 67, 68, 69, 70, 71, 72, 73, 74, 75) um die Stelle herum unter der Halterfläche (32) verteilt angeordnet sind, auf der das Bedienelement (14) sitzt.

11. Bedienvorrichtung nach Anspruch 8 und Anspruch 9 oder 10, **dadurch gekennzeichnet, dass** der Magnet (26, 36) der Erkennungsmittel der Magnet der Stabilisierungseinrichtung ist.

12. Bedienvorrichtung nach einem der vorhergehenden Ansprüche, **dadurch gekennzeichnet, dass** das Bedienelement (14) in mehrere Richtungen kippbar ist, vorzugsweise durch eine kraftgeführte Kippbewegung und/oder.

13. Bedienvorrichtung nach einem der vorhergehenden Ansprüche, **gekennzeichnet durch** einen Magnet an einem höheren Punkt des Bedienelements (14), wobei an oder unter der Halterfläche (32) zwei weitere, voneinander beabstandete Magnete vorgesehen sind, die einen Abstand zu dem Punkt aufweisen, an dem das Bedienelement (14) auf die Halterfläche (30) gesetzt ist, wobei sich bei der Kippbewegung der Magnet in dem Bedienelement (14) einem Punkt zwischen den beiden Magneten nähert, wobei sich der Magnet im Bedienelement (14) und die Magnete an oder unter der Halterfläche (32) gegenseitig abstoßen.

14. Bedienvorrichtung nach einem der vorhergehenden Ansprüche, **gekennzeichnet durch** eine weitere Erkennungseinrichtung (42, 44, 66, 67, 68, 69, 70, 71, 72, 73, 74, 75) zur Erkennung einer Drehbewegung des Bedienelements (14) und Auslösen einer weiteren Bedienfunktion, wobei vorzugsweise diese Erkennungseinrichtung weitere Magnetfeldsensoren (42, 44, 66, 67, 68, 69, 70, 71, 72, 73, 74, 75) an oder unter der Halterfläche (32) aufweist, die mit einem oder mehreren Magneten (26) an oder in dem Bedienelement (14) zusammenwirken.

15. Bedienvorrichtung nach einem der Ansprüche 1 bis 13, **gekennzeichnet durch** eine weitere Erkennungseinrichtung zur Erkennung einer Drehbewegung des Bedienelements (14) und Auslösen einer weiteren Bedienfunktion, wobei sie für kontaktlose Erkennung ausgebildet ist, vorzugsweise optisch mit einem Sensor und einem damit zusammenwirkenden runden bzw. kreisringartigen Sensorauslöser, wobei zwischen dem Sensor und dem Sensorauslöser eine Drehung stattfindet mit Hin- und Zurückrichtung, wobei der Sensorauslöser eine Abfolge von Auslösebereichen und Zwischenbereichen aufweist.

16. Bedienvorrichtung nach einem der vorhergehenden Ansprüche, **gekennzeichnet durch** eine magnetische Rasteinrichtung, die mittels Magnetkraft bzw. zusammenwirkenden Magneten eine Drehbewegung in einzelne Raststufen unterteilt.

## Claims

1. Control device (12) for an electrical appliance, preferably an electrical heating appliance, the control device (12) having a control element (14), which rests in movable and removable manner with a control element underside (28) on a mounting surface (32) with a mounting surface top side (30) by means of a retaining force, **characterized in that** the control element underside (28) in a first surface area (52) is constructed corresponding to the planar mounting surface top side (30) for a stable position of control element (14) in a tilt-stable basic position, the retaining force assisting the basic position, said first surface area (52) being surrounded by a second surface area (54), which has a convexity diverging from the course of the first surface area (52) and retreats from the mounting surface top side (30) in such a way that the control element (14) can be tilted from the basic position in the case of permanent engagement towards the mounting surface, detection means (42, 44, 66, 67, 68, 69, 70, 71, 72, 73, 74, 75) are provided for detecting the position of the control element (14) in the basic position or in some other position and for triggering a control function.

2. Control device according to claim 1, **characterized in that** the control element underside (28) is also substantially planar in the first surface area (52) .

3. Control device according to one of the preceding claims, **characterized in that** the second surface area (54) is curved back in rounded manner away from the other side and is preferably uniformly rounded.

4. Control device according to one of the preceding claims, **characterized in that** the transition between the first surface area (52) and the second surface area (54) has a discontinuous course or a step and in particular connected to one another.

5. Control device according to one of the preceding claims, **characterized in that** the first surface area (52) is annular and the second surface area (54) is constructed in the manner of a spherical cap-shaped ring, the first surface area (52) passing along an annulus directly into the second surface area (54).

6. Control device according to one of the claims 1 to 4, **characterized in that** the first surface area (52) is polygonal, preferably equilateral or uniform, and the second surface area (54) is constructed with extended, prism-like partial faces, the first surface area (52) passing along the outer edges of the polygon directly into the second surface area(54).

7. Control device according to one of the preceding claims, **characterized in that** the retaining force is gravity.

8. Control device according to one of the claims 1 to 6, **characterized by** a stabilizing device for producing the retaining force, preferably in contactless manner, particularly by a magnetic force and preferably on one of the two sides of the control element underside (28) or in the vicinity of the mounting surface (32) is provided an active magnet (26, 36) and on the other side magnetic material or a second active magnet.

9. Control device according to one of the preceding claims, **characterized in that** the detection means (42, 44, 66, 67, 68, 69, 70, 71, 72, 73, 74, 75) are constructed for contactless detection, preferably by magnetic force or a magnetic field (48, 60, 62) and in particular an active magnet (26) is located in control element (14) and under the mounting surface (32) are provided magnetic field sensors (42, 44, 66, 67, 68, 69, 70, 71, 72, 73, 74, 75) for detecting the change in the magnetic field (48, 60, 62) in control element (14) as a result of the tilting of said control element (14), particularly from the basic position towards the mounting surface (30).

10. Control device according to claim 9, **characterized in that** further magnetic field sensors (42, 44, 66, 67, 68, 69, 70, 71, 72, 73, 74, 75) are distributed around the point on which the control element (14) is located beneath the mounting surface (32).

11. Control device according to claim 8, as well as 9 or 10, **characterized in that** the detection means magnet (26, 36) is the stabilizing device magnet.

12. Control device according to one of the preceding claims, **characterized in that** control element (14) can be tilted in several directions, preferably by a force-guided tilting movementand/or.

13. Control device according to one of the preceding claims, **characterized by** a magnet at a higher point of control element (14) and two further, spaced magnets are provided on or beneath mounting surface (32) and have a spacing from the point at which the control element (14) is placed on mounting surface (30) and during the tilting movement the magnet in control element (14) approaches a point between the two magnets, the magnet in the control element (14) and the magnets on or beneath the mounting surface (32) repelling one another.

14. Control device according to one of the preceding claims, **characterized by** a further detection device (42, 44, 66, 67, 68, 69, 70, 71, 72, 73, 74, 75) for detecting a rotary movement of control element (14) and for triggering a further control function and preferably said detection device has further magnetic field sensors (42, 44, 66, 67, 68, 69, 70, 71, 72, 73, 74, 75) on or beneath mounting surface (32), which cooperate with one or more magnets (26) on or in control element (14).

15. Control device according to one of the claims 1 to 13, **characterized by** a further detection device for detecting a rotary movement of control element (14) and for triggering a further control function, it being constructed for contactless detection and preferably in optical manner with a sensor and a circular or annular sensor trigger cooperating therewith, a rotation taking place with forward and return direction between the sensor and sensor trigger, which has a sequence of triggering areas and intermediate areas.

16. Control device according to one of the preceding claims, **characterized by** a magnetic locking device, which by means of magnetic force or cooperating magnets subdivides a rotary movement into individual locking stages.

## Revendications

1. Dispositif de commande (12) pour un appareil électrique, de préférence pour un appareil électrothermique, sachant que le dispositif de commande (12) présente un élément de commande (14), qui est posé de manière déplaçable et détachable par sa face inférieure d'élément de commande (28) sur une surface de rétention (32) qui présente une face supérieure de surface de rétention (30) au moyen d'une force de rétention, **caractérisé en ce que** la face inférieure (28) de l'élément de commande est réalisée dans une première zone de surface (52) de manière à correspondre à la face supérieure (30) plane de la surface de rétention pour obtenir un positionnement stable de l'élément de commande (14) dans une position de base stable par rapport au basculement, sachant que la force de rétention soutient le maintien de la position de base, sachant que cette première zone de surface (52) est entourée d'une deuxième zone de surface (54), qui présente une convexité qui s'écarte de celle de la première zone de surface (52) et qui est par conséquent en retrait par rapport à la face supérieure de surface de rétention (30) de manière que l'élément de commande (14) puisse être basculé à partir de la position de base en direction de la surface de rétention tout en gardant son appui, sachant qu'on prévoit des moyens d'identification (42, 44, 66, 67, 68, 69, 70, 71, 72, 73, 74, 75) pour identifier la position de l'élément de commande (14) qui se trouve en position de base ou dans une autre position et pour déclencher une fonction de service.

2. Dispositif de commande d'après la revendication 1, **caractérisé en ce que** la face inférieure (28) de l'élément de commande dans la première zone de surface (52) est également essentiellement plane.

3. Dispositif de commande d'après une des revendications précédentes, **caractérisé en ce que** la deuxième zone de surface (54) est courbée en arrière de façon arrondie, en s'éloignant de l'autre face, en étant arrondie préférablement de manière uniforme.

4. Dispositif de commande d'après une des revendications précédentes, **caractérisé en ce que** la transition entre la première zone de surface (52) et la deuxième zone de surface (54) présente une allure discontinue ou encore un gradin, sachant notamment qu'elles s'ensuivent.

5. Dispositif de commande d'après une des revendications précédentes, **caractérisé en ce que** la première zone de surface (52) est circulaire et que la deuxième zone de surface (54) est réalisée à la manière d'un anneau partiellement en forme de calotte, sachant que la première zone de surface (52) devient directement la deuxième zone de surface (54) le long d'un anneau circulaire.

6. Dispositif de commande d'après une des revendications de 1 à 4, **caractérisé en ce que** la première zone de surface (52) est polygonale, de préférence équilatérale ou encore régulière, et que la deuxième zone de surface (54) est constituée de surfaces partielles qui s'ensuivent à la manière d'un prisme, sachant que la première zone de surface (52) devient directement la deuxième zone de surface (54) le long des arêtes extérieures du polygone.

7. Dispositif de commande d'après une des revendications précédentes, **caractérisé en ce que** la force de rétention est la force de gravitation.

8. Dispositif de commande d'après une des revendications de 1 à 6, **caractérisé par** un dispositif de stabilisation pour la production de la force de rétention, de préférence sans contact mécanique, notamment par une force magnétique, sachant que de préférence d'un des deux côtés de la face inférieure d'élément de commande (28) ou dans le domaine de la surface de rétention (32) sont disposés un aimant (26, 36) actif et de l'autre côté un matériau magnétique ou bien un autre aimant actif.

9. Dispositif de commande d'après une des revendications précédentes, **caractérisé en ce que** les dispositifs d'identification (42, 44, 66, 67, 68, 69, 70, 71, 72, 73, 74, 75) sont réalisés pour une identification sans contact mécanique, de préférence au moyen d'une force magnétique ou encore au moyen d'un champ magnétique (48, 60, 62), sachant que notamment dans l'élément de commande (14) est disposé un aimant (26) actif et que sous la surface de rétention (32) sont disposés des détecteurs de champ magnétique (42, 44, 66, 67, 68, 69, 70, 71, 72, 73, 74, 75) pour la détection d'un changement du champ magnétique (48, 60, 62) dans l'élément de commande (14) à la suite d'un basculement de l'élément de commande (14), notamment à partir de la position de base en direction de la surface de rétention (30).

10. Dispositif de commande d'après la revendication 9, **caractérisé en ce que** d'autres détecteurs de champ magnétique (42, 44, 66, 67, 68, 69, 70, 71, 72, 73, 74, 75) sont disposés autour de l'endroit au-dessous de la surface de rétention (32), au-dessus duquel est posé l'élément de commande (14).

11. Dispositif de commande d'après la revendication 8 et la revendication 9 ou 10, **caractérisé en ce que** l'aimant (26, 36) des dispositifs d'identification est l'aimant du dispositif de stabilisation.

12. Dispositif de commande d'après une des revendications précédentes, **caractérisé en ce que** l'élément de commande (14) peut être basculé dans plusieurs directions, de préférence par un mouvement de basculement conduit par une force et/ou.

13. Dispositif de commande d'après une des revendications précédentes, **caractérisé par** un aimant dans un endroit plus élevé de l'élément de commande (14), sachant qu'on prévoit deux aimants supplémentaires écartés l'un de l'autre à la ou au-dessous de la surface de rétention (32), qui présentent une distance par rapport à l'endroit, ou l'élément de commande (14) est posé sur la surface de rétention (30), sachant que pendant le mouvement de basculement, l'aimant dans l'élément de commande (14) s'approche d'un endroit entre les deux aimants, sachant que l'aimant dans l'élément de commande (14) et les aimants à la ou au-dessous de la surface de rétention (32) se repoussent.

14. Dispositif de commande d'après une des revendications précédentes, **caractérisé par** un dispositif d'identification (42, 44, 66, 67, 68, 69, 70, 71, 72, 73, 74, 75) supplémentaire pour l'identification d'un mouvement rotatoire de l'élément de commande (14) et le déclenchement d'une fonction de service supplémentaire, sachant que de préférence ce dispositif d'identification présente des détecteurs de champ magnétique (42, 44, 66, 67, 68, 69, 70, 71, 72, 73, 74, 75) supplémentaires à la ou au-dessous de la surface de rétention (32), qui agissent conjointement avec un ou plusieurs aimants (26) auprès de ou dans l'élément de commande (14).

15. Dispositif de commande d'après une des revendications de 1 à 13, **caractérisé par** un dispositif d'identification supplémentaire pour l'identification d'un mouvement rotatoire de l'élément de commande (14) et pour le déclenchement d'une fonction de service supplémentaire, sachant qu'il est réalisé pour une identification sans contact mécanique, de préférence optique avec un détecteur et un déclencheur de détecteur rond ou encore en forme d'anneau circulaire qui agit conjointement avec le détecteur, sachant qu'entre le détecteur et le déclencheur de détecteur a lieu un mouvement rotatoire avec une direction d'allée et de retour, sachant que le déclencheur de détecteur présente une succession de zones de déclenchement et de zones intermédiaires.

16. Dispositif de commande d'après une des revendications précédentes, **caractérisé par** un dispositif à crans magnétiques, qui subdivise un mouvement rotatoire en crans individuels par une force magnétique ou encore par l'emploi d'aimants à action conjointe.
